# EUROPEAN PATENT SPECIFICATION

(11) **EP 3 799 314 B1**
(45) Date of publication and mention of the grant of the patent: **26.07.2023**
(21) Application number: 20171241.1
(22) Date of filing: 20.02.2014
(51) Int. Cl.: H03M 13/13, H03M 13/27, H04L 1/00, H04L 1/18

(54) **RATE MATCHING WITH SUB-BLOCK INTERLEAVING AND A VIRTUAL BUFFER FOR POLAR CODES**
RATENANPASSUNG MIT SUB-BLOCK-VERSCHACHTELUNG UND VIRTUELLEM PUFFER FÜR POLAR KODES
L'ADAPTATION DU DÉBIT AVEC ENTRELACEMENT DES SOUS-BLOCS ET UN TAMPON VIRTUEL POUR LES CODES POLAIRES

(43) Date of publication of application: 31.03.2021
(62) Divisional of application: 14883364.3
(73) Proprietor: Huawei Technologies Co., Ltd., Shenzhen, Guangdong 518129 (CN)
(72) Inventor: CHEN, Jun, Shenzhen, Guangdong 518129 (CN); LI, Bin, Shenzhen, Guangdong 518129 (CN); SHEN, Hui, Shenzhen, Guangdong 518129 (CN)
(74) Representative: Maiwald GmbH

(56) References cited:
- WO-A2-2009/025495
- US-A1- 2007 030 917
- US-A1- 2010 058 136
- "3rd Generation Partnership Project; Technical Specification Group Radio Access Network; Evolved Universal Terrestrial Radio Access (E-UTRA); Multiplexing and channel coding (Release 11)", 3GPP STANDARD; 3GPP TS 36.212, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. V11.3.0, 17 June 2013 (2013-06-17), pages 1-84, XP050692826, [retrieved on 2013-06-17]
- "Universal Mobile Telecommunications System (UMTS); Multiplexing and channel coding (FDD) (3GPP TS 25.212 version 6.5.0 Release 6); ETSI TS 125 212", TECHNICAL SPECIFICATION, EUROPEAN TELECOMMUNICATIONS STANDARDS INSTITUTE (ETSI), 650 ROUTE DES LUCIOLES, SOPHIA ANTIPOLIS CEDEX, F-06921, FRANCE, vol. 3-R1, no. V6.5.0, 1 June 2005 (2005-06-01), XP014030540,
- MOTOROLA: "Convolutional code rate matching in LTE", 3GPP DRAFT; R1-073360_CONV_RATEMATCH_VFINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. Athens, Greece; 20070815, 15 August 2007 (2007-08-15), XP050106989, [retrieved on 2007-08-15]
- ALI ESLAMI ET AL: "A Practical Approach to Polar Codes", ARXIV.ORG, CORNELL UNIVERSITY LIBRARY, 201 OLIN LIBRARY CORNELL UNIVERSITY ITHACA, NY 14853, 27 July 2011 (2011-07-27), XP080517802, DOI: 10.1109/ISIT.2011.6033837
- CHEN KAI ET AL: "A Hybrid ARQ Scheme Based on Polar Codes", IEEE COMMUNICATIONS LETTERS., [Online] vol. 17, no. 10, 1 October 2013 (2013-10-01), pages 1996-1999, XP055777086, US ISSN: 1089-7798, DOI: 10.1109/LCOMM.2013.090213.131670 Retrieved from the Internet: URL:https://ieeexplore.ieee.org/stampPDF/g etPDF.jsp?tp=&arnumber=6589284&ref=aHR0cHM 6Ly9pZWVleHBsb3JlLmllZWUub3JnL2RvY3VtZW50L zY1ODkyODQ=> [retrieved on 2021-02-17]

## Description

### TECHNICAL FIELD

Embodiments of the present invention relate to communications technologies, and in particular, to a rate matching processing method and apparatus for coding.

### BACKGROUND

At present, a basic principle of Polar code is to determine a row vector (or column vector) of a coding matrix according to a particular condition by using a Bhattacharyya parameter or a capacity (symmetric capacity), or to determine a row vector (or column vector) of a corresponding coding matrix by using a bit error rate. In this way, the Polar code can obtain better performance, for example: a better bit error rate or transmission rate, by using the row vector (or column vector) of the coding matrix selected in the foregoing manner.

In addition, the Polar code may further support a hybrid automatic repeat request (Hybrid Automatic Repeat Request; HARQ for short) function by using a two-step rate matching algorithm. Specifically, a specific implementation manner of rate matching processing of the Polar code is: dividing coded bits output by a Polar encoder into three groups, and performing an independent and uniform puncturing operation or repetition operation on each group, so that a length of a coded bit can be matched to a size of a virtual incremental redundancy buffer (Incremental Redundancy buffer; IR buffer for short) and a size of a transmission resource.

However, when the two-step rate matching algorithm is used, coded bits output by a Polar encoder need to be divided into three groups, which therefore conflicts with selection of a row vector (or column vector) of a coding matrix of Polar code. That is, in a case in which an arrangement order and an output order of priority bits are not considered, a row vector (or column vector) of a coding matrix cannot be selected in the foregoing manner, and consequently a loss in a performance gain occurs during decoding, causing severe decoding error transmission, and further causing a problem of poor performance of the Polar code. "3^{rd} Generation Partnership Project: Technical Specification Group Radio Access Network:
Evolved Universal Terrestrial Radio Access (E-UTRA); Multiplexing and channel coding (Release 11)", 3GPP TS 36.212, discloses that rate matching for convolutionally coded transport channels and control information consists of interleaving the three bits streams, followed by collection of bits and the generation of a circular buffer.
"Universal Mobile Telecommunications System (UMTS); Multiplexing and channel coding (FDD)" (3GPP TS 25.212 version 6.5.0 Release 6), ETSI TS125 212, discloses a rate matching scheme of turbo code.
Motorola "convolutional code rate matching in LTE", R1-073360, discloses an circular buffer based rate matching algorithm includes separating the three parity bit subblocks, performing a subblock interleaving on each subblock individually and forming a circular buffer by concatenating the interleaved subblocks.
ALI ESLAMI ET AL: "A practical approach to polar codes", ARXIV.ORG, CORNELL UNIVERSITY LIBRARY, 27 July 2011 discloses two rare compatible coding scheme using polar codes, including puncturing procedure.
CHEN KAI ET AL: "A hybrid ARQ Scheme Based on Polar Codes" IEEE COMMUNICATIONS LETTERS, (1, October 2013) discloses an hybrid automatic repeat request (HARQ) transmission scheme of polar codes by puncturing and repetition.

### SUMMARY

The present invention is defined by the appended claims.

Because coded bits output by a Polar encoder are randomly divided into multiple groups, and bit reduction processing or bit reduction processing and bit repetition processing are performed on the multiple groups continuously, not only an efficient and flexible rate matching technology can be supported, but also HARQ retransmission can be supported, and transmission efficiency can be further improved.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show some embodiments of the present invention, and persons of ordinary skill in the art may still derive other drawings from these accompanying drawings without creative efforts.
FIG. 1 is a flowchart of an embodiment of a rate matching processing method for coding according to the present invention;
FIG. 2 is a flowchart of another embodiment of a rate matching processing method for coding according to the present invention;
FIG. 3 is a flowchart of still another embodiment of a rate matching processing method for coding according to the present invention;
FIG. 4 is a flowchart of yet another embodiment of a rate matching processing method for coding according to the present invention;
FIG. 5 is a schematic structural diagram of an embodiment of a rate matching processing apparatus for coding according to the present invention; and
FIG. 6 is a schematic structural diagram of another embodiment of a rate matching processing apparatus for coding according to the present invention.

### DESCRIPTION OF EMBODIMENTS

To make the objectives, technical solutions, and advantages of the embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by persons of ordinary skill in the art based on the embodiments of the present invention without creative efforts shall fall within the protection scope of the present invention.

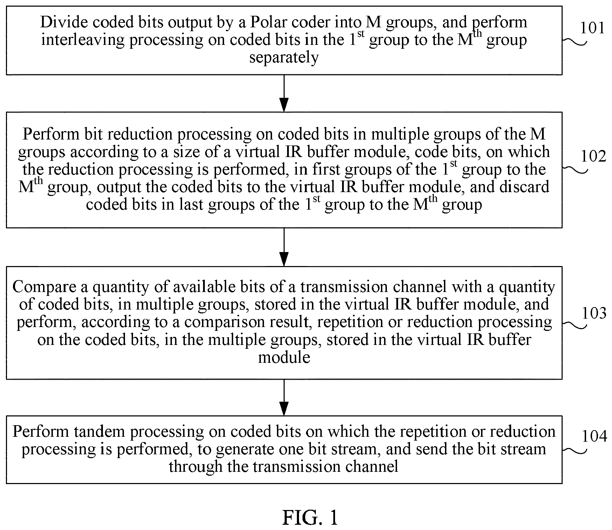

FIG. 1 is a flowchart of an embodiment of a rate matching processing method for coding according to the present invention. As shown in FIG. 1, the method in this embodiment may include:
Step 101: Divide coded bits output by a Polar encoder into M groups, and perform interleaving processing on coded bits in the 1st group to the Mth group separately.

In this embodiment, coded bits output by the Polar encoder may be systematic Polar coded bits or non-systematic Polar coded bits.

Step 102: Perform bit reduction processing on coded bits in multiple groups of the M groups according to a size of a virtual IR buffer module, code bits, on which the reduction processing is performed, in first groups of the 1^{st} group to the M ^{th} group, output the coded bits to the virtual IR buffer module, and discard coded bits in last groups of the 1^{st} group to the *M* ^{th} group.

Step 103: Compare a quantity of available bits of a transmission channel with a quantity of coded bits, in multiple groups, stored in the virtual IR buffer module, and perform, according to a comparison result, repetition or reduction processing on the coded bits, in the multiple groups, stored in the virtual IR buffer module.

In this embodiment, a quantity of available bits of a transmission channel is a quantity of available resources of a physical layer air interface.

In this embodiment, if the quantity of the coded bits, in the multiple groups, stored in the virtual IR buffer module is greater than or equal to the quantity of available bits of the transmission channel, bit reduction processing is performed, that is, first coded bits of a group corresponding to a selected start position are output preferentially, and rest coded bits are discarded. In addition, if the quantity of the coded bits, in the multiple groups, stored in the virtual IR buffer module is less than the quantity of available bits of the transmission channel, bit repetition processing is performed, and starting from the group corresponding to the selected start position, coded bits of groups are output cyclically and repeatedly, first coded bits of the groups are output preferentially, and last coded bits are discarded.

The selected start position may be pre-defined, or is a Hybrid Automatic Repeat Request, HARQ for short, Redundancy Version; RV for short) indication sent by a wireless communications system.

Step 104: Perform concatenation processing on coded bits on which the repetition or reduction processing is performed, to generate one bit stream, and send the bit stream through the transmission channel.

In this embodiment, coded bits output by a Polar encoder are divided into M groups, and interleaving processing is performed on coded bits in the 1^{st} group to the M^{th} group separately; bit reduction processing is performed on coded bits in multiple groups of the *M* groups according to a size of a virtual IR buffer module, bits, on which the reduction processing is performed, in first groups of the 1^{st} group to the M^{th} group are coded and output to the virtual IR buffer module, and coded bits in last groups of the 1^{st} group to the M ^{th} group are discarded; a quantity of available bits of a transmission channel is compared with a quantity of coded bits, in multiple groups, stored in the virtual IR buffer module, and repetition or reduction processing is performed, according to a comparison result, on the coded bits, in the multiple groups, stored in the virtual IR buffer module; and concatenation processing is performed on coded bits on which the repetition or reduction processing is performed, to generate one bit stream, and the bit stream is output through the transmission channel. Because coded bits output by a Polar encoder are randomly divided into multiple groups, and bit reduction processing or bit reduction processing and bit repetition processing are performed on the multiple groups continuously, not only an efficient and flexible rate matching technology can be supported, but also HARQ retransmission can be supported, and transmission efficiency can be further improved.

The technical solution in the method embodiment shown in FIG. 1 is described in detail below by using several specific embodiments.

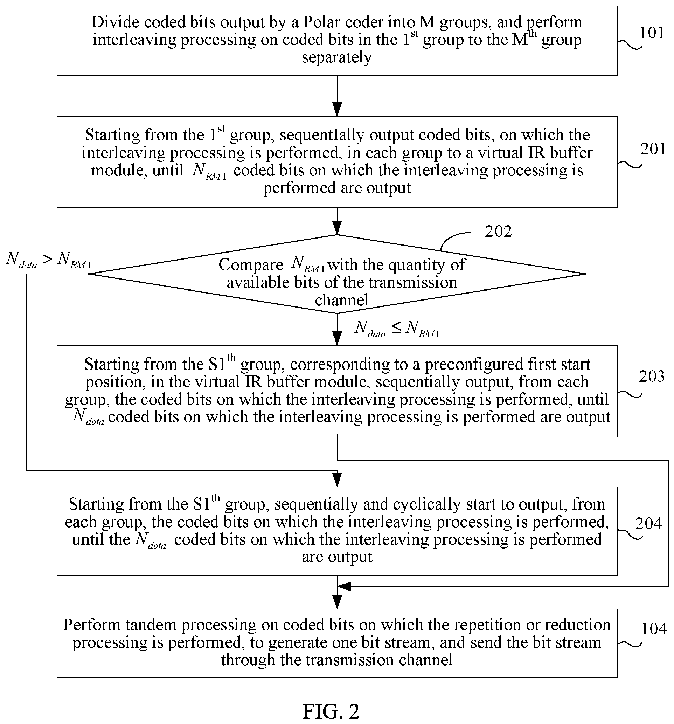

FIG. 2 is a flowchart of another embodiment of a rate matching processing method for coding according to the present invention. On a basis of the foregoing embodiment shown in FIG. 1, as shown in FIG. 2, in this embodiment, an example in which coded bits output by a Polar encoder may be non-systematic Polar coded bits is used, that is, the *j* ^{th} group includes *f_{N}*(*j*) coded bits, *f_{N}*(*j*) represents a substitution function, and *j*=(*i*-1)*P*+*t*, where *i*=1,2,···,*M*, *t*=0,1,···,*P*-1, and *P* = *N* / *M* ; *N* is a positive integer and represents a length of a coded bit output by the Polar encoder. The technical solution in this embodiment is described in detail, and a specific implementation manner of step 102 is:

Step 201: Starting from the 1^{st} group, sequentially output coded bits, on which the interleaving processing is performed, in each group to the virtual IR buffer module, until *N*_{*RM*1} coded bits on which the interleaving processing is performed are output, where *N*_{*RM*1} = min(*N*,*N_{IR}*), and *N_{IR}* represents the size of the virtual IR buffer module.

Optionally, a specific implementation manner of step 103 is:

Step 202: Compare *N*_{*RM*1} with the quantity of available bits of the transmission channel. If *N_{data}*≤*N*_{*RM*1}, perform step 203; if *N_{data}*>*N*_{*RM*1}, perform step 204.

Step 203: Starting from the S1^{th} group, corresponding to a preconfigured first start position, in the virtual IR buffer module, sequentially output, from each group, the coded bits on which the interleaving processing is performed, until *N_{data}* coded bits on which the interleaving processing is performed are output.

Step 204: Starting from the S1^{th} group, sequentially and cyclically start to output, from each group, the coded bits on which the interleaving processing is performed, until the *N_{data}* coded bits on which the interleaving processing is performed are output, where *N_{data}* represents the quantity of available bits of the transmission channel.

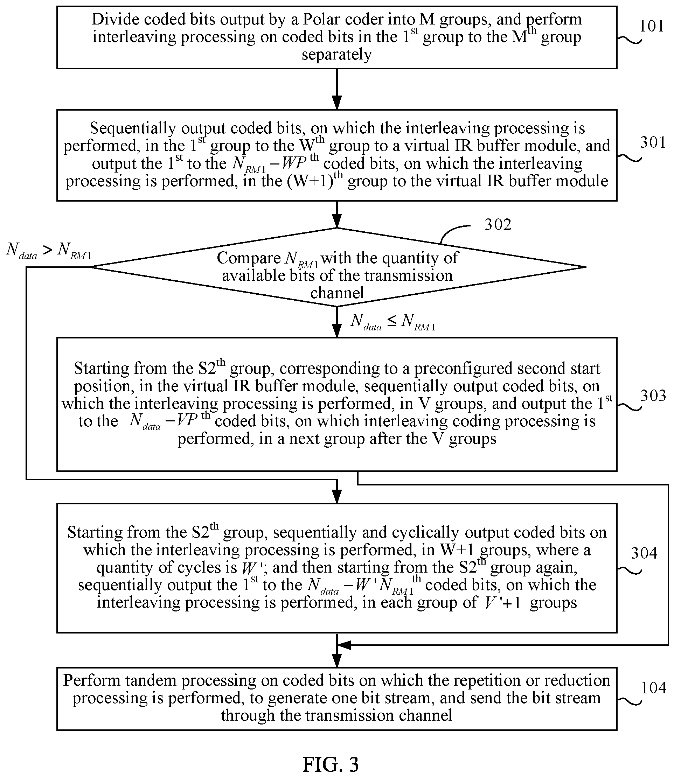

FIG. 3 is a flowchart of still another embodiment of a rate matching processing method for coding according to the present invention. On a basis of the foregoing embodiment shown in FIG. 1, as shown in FIG. 3, in this embodiment, an example in which coded bits output by a Polar encoder may be non-systematic Polar coded bits is used, that is, the *j* ^{th} group includes *f_{N}*(*j*) coded bits, *f_{N}*(*j*) represents a substitution function, and *j*=(*i*-1)*P*+*t*, where *i*=1,2,···,*M*, *t*=0,1,···,*P*-1, and *P* = *N* / *M* ; *N* is a positive integer and represents a length of a coded bit output by the Polar encoder. The technical solution in this embodiment is described in detail, and another specific implementation manner of step 102 is:
Step 301: Sequentially output coded bits, on which the interleaving processing is performed, in the 1^{st} group to the W^{th} group to the virtual IR buffer module, and output the 1^{st} to the *N*_{*RM*1} -*WP*^{th} coded bits, on which the interleaving processing is performed, in the (W+1)^{th} group to the virtual IR buffer module.

W meets *WP* < *N*_{*RM*1} ≤(*W* +1)*P*, *N*_{*RM*1} =min(*N,N_{IR}*), and *N_{IR}* represents the size of the virtual IR buffer module.

Optionally, another specific implementation manner of step 103 is:
Step 302: Compare *N*_{*RM*1} with the quantity of available bits of the transmission channel. If *N_{data}*≤*N*_{*RM*1}, perform step 303; if *N_{data}*>*N*_{*RM*1}, perform step 304.
Step 303: Starting from the S2^{th} group, corresponding to a preconfigured second start position, in the virtual IR buffer module, sequentially output coded bits, on which the interleaving processing is performed, in V groups, and output the 1^{st} to the *N_{data}* - *VP*ₜₕ coded bits, on which interleaving coding processing is performed, in a next group after the V groups.

V meets *VP* < *N_{data}* ≤ (*V*+1)*P*; and *N_{data}* represents the quantity of available bits of the transmission channel.

Step 304: Starting from the S2^{th} group, sequentially and cyclically output coded bits on which the interleaving processing is performed, in W+1 groups, where a quantity of cycles is *W*'; and then starting from the S2^{th} group again, sequentially output the 1^{st} to the *N_{data}* -*W'N*_{*RM*1^{th}} coded bits, on which the interleaving processing is performed, in each group of *V*'+1 groups. *W*' meets *W'P*<*Ndata* ≤ (*W*'+1)*N*_{*RM*1} , *V*' meets *V'P*<*N_{data} -W'NN*_{*RM*1} ≤(*V'*+1)*P*, and *N_{data}* represents the quantity of available bits of the transmission channel.

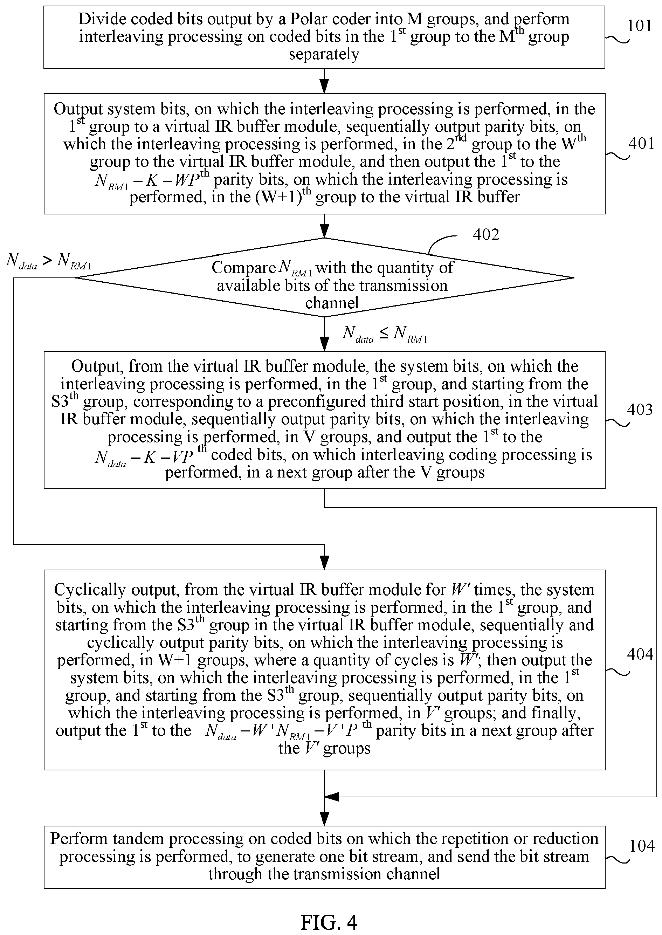

FIG. 4 is a flowchart of yet another embodiment of a rate matching processing method for coding according to the present invention. On a basis of the foregoing embodiment shown in FIG. 1, as shown in FIG. 4, in this embodiment, an example in which coded bits output by a Polar encoder may be systematic Polar coded bits is used, that is, the 1^{st} group includes system bits, the 2^{nd} group to the M^{th} group include parity bits, the *j*^{th} group includes *f_{N-K}* (*j*) parity bits, *f_{N}*(*j*) represents a substitution function, and *j*=(*i*-1)*P*+*t*, where *i*=1,2,···,*M*-1, *t*=0,1,···,*P*-1, and *P*=(*N-K*)/(*M*-1); *N* is a positive integer and represents a length of a coded bit output by the Polar encoder; *K* represents the foremost *K* bits of the coded bits output by the Polar encoder. The technical solution in this embodiment is described in detail, and still another specific implementation manner of step 102 is:
Step 401: Output system bits, on which the interleaving processing is performed, in the 1^{st} group to the virtual IR buffer module; sequentially output parity bits, on which the interleaving processing is performed, in the 2^{nd} group to the W^{th} group to the virtual IR buffer module; and then output the 1^{st} to the *N*_{*RM*1} -*K*-*WP*ₜₕ parity bits, on which the interleaving processing is performed, in the (W+1)^{th} group to the virtual IR buffer; where W meets *WP*<*N*_{*RM*1} *- K*≤(*W*+1)*P*, *N*_{*RM*1} = min(*N*,*N_{IR}*), and *N_{IR}* represents the size of the virtual IR buffer.

Optionally, still another specific implementation manner of step 103 is:

Step 402: Compare *N*_{*RM*1} with the quantity of available bits of the transmission channel. If *N_{data}*≤*N*_{*RM*1}, perform step 403; if *N_{data}*>*N*_{*RM*1}, perform step 404.

Step 403: Output, from the virtual IR buffer module, the system bits, on which the interleaving processing is performed, in the 1^{st} group; and starting from the S3^{th} group, corresponding to a preconfigured third start position, in the virtual IR buffer module, sequentially output parity bits, on which the interleaving processing is performed, in V groups, and output the 1^{st} to the *N_{data}-K*-*VP*ₜₕ coded bits, on which interleaving coding processing is performed, in a next group after the V groups, where V meets *VP* < *N_{data} - K*≤(*V*+1)*P*, and *N_{data}* represents the quantity of available bits of the transmission channel.

Step 404: Cyclically output, from the virtual IR buffer module for *W*' times, the system bits, on which the interleaving processing is performed, in the 1^{st} group; starting from the S3^{th} group in the virtual IR buffer module, sequentially and cyclically output parity bits, on which the interleaving processing is performed, in W+1 groups, where a quantity of cycles is *W*'; then output the system bits, on which the interleaving processing is performed, in the 1^{st} group, and starting from the S3^{th} group, sequentially output parity bits, on which the interleaving processing is performed, in *V*' groups; and finally, output the 1^{st} to the *N_{data} -W*'*N*_{*RM*1} -*V*'*P*^{th} parity bits in a next group after the *V*' groups; where *W*' meets *W'P*<*N_{data}* ≤(*W*'+1)*N*_{*RM*1}, *V*' meets *V*'*P*<*N_{data}*-*W*'*N*_{*NR*1} ≤(*V*'+1)*P*, and *N_{data}* represents the quantity of available bits of the transmission channel.

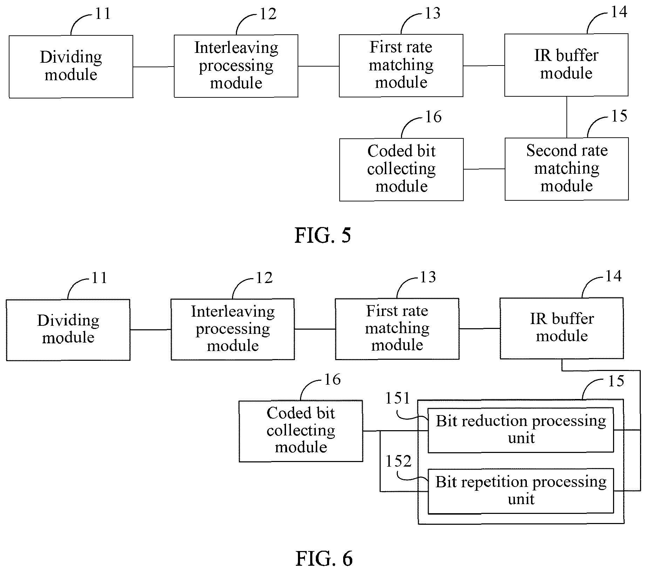

FIG. 5 is a schematic structural diagram of an embodiment of a rate matching processing apparatus for coding according to the present invention. As shown in FIG. 5, the apparatus of this embodiment may include: a dividing module 11, an interleaving processing module 12, a first rate matching module 13, an IR buffer module 14, a second rate matching module 15, and a coded bit collecting module 16, where the dividing module 11 is configured to divide coded bits output by a Polar encoder into M groups, where *M* is a positive integer; the interleaving processing module 12 is configured to perform interleaving processing on coded bits in the 1^{st} group to the *M*^{th} group separately; the first rate matching module 13 is configured to perform bit reduction processing on coded bits in multiple groups of the *M* groups according to a size of the virtual IR buffer module 14, code bits, on which the reduction processing is performed, in first groups of the 1^{st} group to the M^{th} group, output the coded bits to the virtual IR buffer module 14, discard coded bits in last groups of the 1^{st} group to the *M* ^{th} group, and discard the coded bits of the last groups; the IR buffer module 14 is configured to store coded bits, in multiple groups, output by the first rate matching module; the second rate matching module 15 is configured to compare a quantity of available bits of a transmission channel with a quantity of coded bits, in multiple groups, stored in the virtual IR buffer module, and perform, according to a comparison result, repetition or reduction processing on the coded bits, in the multiple groups, stored in the virtual IR buffer module 14; and the coded bit collecting module 16 is configured to perform concatenation processing on coded bits on which the repetition or reduction processing is performed, to generate one bit stream, and send the bit stream through the transmission channel.

The apparatus in this embodiment may be configured to execute the technical solution in the method embodiment shown in FIG. 1. Implementation principles and technical effects of this embodiment and the method embodiment are similar, and details are not described herein again.

FIG. 6 is a schematic structural diagram of another embodiment of a rate matching processing apparatus for coding according to the present invention. As shown in FIG. 6, on a basis of the apparatus structure shown in FIG. 5, in the apparatus in this embodiment, when the *j*^{th} group includes *f_{N}*(*j*) coded bits, *f_{N}*(*j*) represents a substitution function, *j*=(*i*-1)*P*+*t*, where *i*=1,2,···,*M*, *t*=0,1,···,*P*-1, and *P*=*N*/*M*, *N* is a positive integer, and *N* represents a length of a coded bit output by the Polar encoder, the first rate matching module 13 is specifically configured to: starting from the 1^{st} group, sequentially output coded bits, on which the interleaving processing is performed, in each group to the virtual IR buffer module 14, until *N*_{*RM*1} coded bits on which the interleaving processing is performed are output, where *N*_{*RM*1} =min(*N*,*N_{IR}*), and *N_{IR}* represents the size of the virtual IR buffer module 14.

Optionally, the second rate matching module 15 includes: a bit reduction processing unit 151 and a bit repetition processing unit 152, where the bit reduction processing unit 151 is configured to: when *N_{data}*≤*N*_{*RM*1}, starting from the S1^{th} group, corresponding to a preconfigured first start position, in the virtual IR buffer module, sequentially output, from each group, the coded bits on which the interleaving processing is performed, until *N_{data}* coded bits on which the interleaving processing is performed are output; and the bit repetition processing unit 152 is configured to: when *N_{data}*>*N*_{*RM*1}, starting from the S1^{th} group, sequentially and cyclically start to output, from each group, the coded bits on which the interleaving processing is performed, until the *N_{data}* coded bits on which the interleaving processing is performed are output, where *N_{data}* represents the quantity of available bits of the transmission channel.

The apparatus in this embodiment may be configured to execute the technical solution in the method embodiment shown in FIG. 2. Implementation principles and technical effects of this embodiment and the method embodiment are similar, and details are not described herein again.

Further, in still another embodiment of the present invention, on a basis of the foregoing embodiment shown in FIG. 5, when the *j* ^{th} group includes *f_{N}*(*j*) coded bits, *f_{N}*(*j*) represents a substitution function, *j*=(*i*-1)*P*+*t*, where *i*=1,2,···,*M*, *t*=0,1,···,*P*-1, and *P* = *N* / *M*, *N* is a positive integer, and *N* represents a length of a coded bit output by the Polar encoder, the first rate matching module 13 is specifically configured to: sequentially output coded bits, on which the interleaving processing is performed, in the 1^{st} group to the W^{th} group to the virtual IR buffer module 14, and output the 1^{st} to the *N*_{*RM*1} - *WP*^{th} coded bits, on which the interleaving processing is performed, in the (*W*+1)^{th} group to the virtual IR buffer module 14, where W meets *WP < N*_{*RM*1} ≤ (*W* + 1)*P*, *N*_{*RM*1} = min(*N*,*N_{IR}*), and *N_{IR}* represents the size of the virtual IR buffer module 14.

Optionally, the second rate matching module 15 includes: a bit reduction processing unit and a bit repetition processing unit, where the bit reduction processing unit is configured to: when *N_{data}*≤N_{*RM*1}, starting from the S2^{th} group, corresponding to a preconfigured second start position, in the virtual IR buffer module 14, sequentially output coded bits, on which the interleaving processing is performed, in V groups, and output the 1^{st} to the *N_{data}* - *VP*^{th} coded bits, on which interleaving coding processing is performed, in a next group after the V groups, where V meets *VP* < *N_{data}* ≤(*V*+1)*P*; and *N_{data}* represents the quantity of available bits of the transmission channel; and the bit repetition processing unit is configured to: when *N_{data}*>*N*_{*RM*1}, starting from the S2^{th} group, sequentially and cyclically output coded bits, on which the interleaving processing is performed, in W+1 groups, where a quantity of cycles is *W*'; and then starting from the S2^{th} group again, sequentially output the 1^{st} to the *N_{data} -W'N*_{*RM*1^{th}} coded bits, on which the interleaving processing is performed, in each group of *V*'+1 groups; where *W*' meets *W'P*<*N_{data}* ≤(*W'*+1)*N*_{*RM*1}, *V*' meets *V'P*<*N_{data} -W'NN*_{*RM*1} ≤(*V'*+1)*P*, and *N_{data}* represents the quantity of available bits of the transmission channel.

The apparatus in this embodiment may be configured to execute the technical solution in the method embodiment shown in FIG. 3. Implementation principles and technical effects of this embodiment and the method embodiment are similar, and details are not described herein again.

Further, in yet another embodiment of the present invention, on a basis of the foregoing embodiment shown in FIG. 5, when the 1^{st} group includes system bits, the 2^{nd} group to the M^{th} group include parity bits, the *j*^{th} group includes *f_{N-K}*(*j*) parity bits, *f_{N}*(*j*) represents a substitution function, *j*=(*i*-1)*P*+*t*, where *i*=1,2,···,*M*-1, *t*=0,1,···,*P*-1, and *P*=(*N-K*)/(*M*-1), *N* is a positive integer and represents a length of a coded bit output by the Polar encoder, and *K* represents the foremost *K* bits of the coded bits output by the Polar encoder, the first rate matching module 13 is specifically configured to output system bits, on which the interleaving processing is performed, in the 1^{st} group to the virtual IR buffer module 14, sequentially output parity bits, on which the interleaving processing is performed, in the 2^{nd} group to the W^{th} group to the virtual IR buffer module 14, and then output the 1^{st} to the *N*_{*RM*1} -*K*-*WP*^{th} parity bits, on which the interleaving processing is performed, in the (W+1)^{th} group to the virtual IR buffer module 14, where W meets *WP<N*_{*RM*1}*-K*≤(*W*+1)*P*, *N*_{*RM*1} =min(*N*,*N_{IR}*), and *N_{IR}* represents the size of the virtual IR buffer module 14.

Optionally, the second rate matching module 15 includes: a bit reduction processing unit and a bit repetition processing unit, where the bit reduction processing unit is configured to: when *N_{data}*≤*N*_{*RM*1}, output, from the virtual IR buffer module, the system bits, on which the interleaving processing is performed, in the 1^{st} group, and starting from the S3^{th} group, corresponding to a preconfigured third start position, in the IR buffer, sequentially output parity bits, on which the interleaving processing is performed, in V groups, and output the 1^{st} to the *N_{data} -K-VP*^{th} coded bits, on which interleaving coding processing is performed, in a next group after the V groups, where V meets *VP < N_{data} - K*≤(*V*+1)*P*, and *N_{data}* represents the quantity of available bits of the transmission channel; and the bit repetition processing unit is configured to: when *N_{data}*>*N*_{*RM*1}, cyclically output, from the virtual IR buffer module for *W*' times, the system bits, on which the interleaving processing is performed, in the 1^{st} group, and starting from the S3^{th} group in the virtual IR buffer module, sequentially and cyclically output parity bits, on which the interleaving processing is performed, in W+1 groups, where a quantity of cycles is *W*'; then output the system bits, on which the interleaving processing is performed, in the 1^{st} group, and starting from the S3^{th} group, sequentially output parity bits, on which the interleaving processing is performed, in *V*' groups; and finally, output the 1^{st} to the *N_{data} -W*'*N*_{*RM*1} -*V'P*^{th} parity bits in a next group after the *V*' groups, where *W*' meets *W'P*<*N_{data}* ≤(*W'*+1)*N*_{*RM*1} ; *V*' meets *V'P* < *N_{data}* -*W*'*NN*_{*RM*1} ≤(*V'*+1)*P* ; and *N_{data}* represents the quantity of available bits of the transmission channel.

The apparatus in this embodiment may be configured to execute the technical solution in the method embodiment shown in FIG. 4. Implementation principles and technical effects of this embodiment and the method embodiment are similar, and details are not described herein again.

Persons of ordinary skill in the art may understand that all or some of the steps of the method embodiments may be implemented by a program instructing relevant hardware. The program may be stored in a computer-readable storage medium. When the program runs, the steps of the method embodiments are performed. The foregoing storage medium includes: any medium that can store program code, such as a ROM, a RAM, a magnetic disk, or an optical disc.

Finally, it should be noted that the foregoing embodiments are merely intended for describing the technical solutions in the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions in the embodiments of the present invention.

## Claims

1. A rate matching processing method for coding, comprising:
dividing (101) N coded bits output by a polar encoder into M groups, and performing interleaving processing on the coded bits in the 1^{st} group to the M^{th} group separately, wherein N and M are positive integers;
sequentially outputting (201) *N*_{*RM*1} coded bits on which the interleaving processing is performed, starting from the 1^{st} group, into a virtual IR buffer module, wherein *N*_{*RM*1} =min(*N*,*N_{IR}*), *N*_{*RM*1} is a positive integer, and *N_{IR}* represents a size of the virtual IR buffer module;
comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction, wherein *N_{data}* is a positive integer; and
concatenating and sending (104), through the transmission channel, the bits after repetition or reduction, wherein a quantity of the bits after repetition or bits after reduction is equal to *N_{data}*.

2. The method according to claim 1, wherein the comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction comprises:
when *N_{data}* > *N*_{*RM*1}, performing repetition processing on the coded bits stored in the virtual IR buffer module, to obtain the bits after repetition.

3. The method according to claim 1 or 2, wherein the comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction comprises:
when *N_{data}* > *N*_{*RM*1} , starting from the S 1^{st} group to the M^{th} group in the M groups, sequentially and cyclically outputting the coded bits on which the interleaving processing is performed, until the quantity of the bits after repetition reaches *N_{data}*.

4. The method according to claim 1, wherein the comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction comprises:
when *N_{data} < N_{RM1}*, performing reduction processing on the coded bits stored in the virtual IR buffer module, to obtain the reduced bits.

5. The method according to claim 1 or 4, wherein the comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction comprises:
when *N_{data} < N_{RM1}*, starting from the S1^{th} group to the M^{th} group in the M groups, corresponding to a preconfigured first start position, in the virtual IR buffer module, sequentially outputting the coded bits on which the interleaving processing is performed, until the quantity of the bits after reduction reaches *N_{data}*.

6. A rate matching processing apparatus for coding, comprising:
a dividing module(11), configured to divide N coded bits output by a polar encoder into M groups, wherein N and M are positive integers;
an interleaving processing module(12), configured to perform interleaving processing on the coded bits in the 1^{st} group to the M^{th} group separately;
a first rate matching module(13), configured to sequentially output N RMl coded bits on which the interleaving processing is performed, starting from the 1^{st} group, into a virtual IR buffer module, wherein *N*_{*RM*1} = min(*N,N_{IR}*), *N*_{*RM*1} is a positive integer, and *N_{IR}* represents a size of the virtual IR buffer module;
a second rate matching module(15), configured to compare *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction, wherein *N_{data}* is a positive integer;
a coded bit collecting module(16), configured to concatenate and send, through the transmission channel, the bits after repetition or reduction, wherein a quantity of the repeated bits or the reduced bits is equal to *N_{data}* .

7. The apparatus according to claim 6, wherein the second rate matching module(15) comprises:
a bit repetition processing unit(152), configured to: when *N_{data}* > *N*_{*RM*1}, starting from the S1^{st} group to the M^{th} group in the M groups, sequentially and cyclically outputting the coded bits on which the interleaving processing is performed, until the quantity of the bits after repetition reaches *N*_{*data*.}

8. The apparatus according to claim 6, wherein the second rate matching module(15) comprises:
a bit reduction processing unit(151), configured to: when *N_{data} < N_{RM1}*, starting from the S1^{th} group to the M^{th} group in the M groups, corresponding to a preconfigured first start position, in the virtual IR buffer module, sequentially outputting the coded bits on which the interleaving processing is performed, until the quantity of the bits after reduction reaches *N_{data}*.

9. A computer-readable storage medium storing a program which, when the program is executed by a computer, causes the computer to perform the steps of:
dividing (101) N coded bits output by a polar encoder into M groups, and performing interleaving processing on the coded bits in the 1^{st} group to the M^{th} group separately, wherein N and M are positive integers;
sequentially outputting (201) *N*_{*RM*1} coded bits on which the interleaving processing is performed, starting from the 1st group, into a virtual IR buffer module, wherein *N*_{*RM*1} =min(*N*,*N_{IR}*), *N*_{*RM*1} is a positive integer, and *N_{IR}* represents a size of the virtual IR buffer module;
comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction, wherein *N_{data}* is a positive integer; and
concatenating and sending, through the transmission channel, the bits after repetition or bits after reduction.

10. The computer-readable storage medium according to claim 9, wherein the comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction comprises:
when *N_{data}* > *N*_{*RM*1}, starting from the S 1^{st} group to the M^{th} group in the M groups, sequentially and cyclically outputting the coded bits on which the interleaving processing is performed, until the quantity of the bits after repetition reaches *N_{data}*.

11. The computer-readable storage medium according to claim 9, wherein the comparing (203) *N_{data}*, a quantity of available bits of a transmission channel, with *N*_{*RM*1}, and performing, according to a comparison result, repetition or reduction processing on the coded bits stored in the virtual IR buffer module, to obtain bits after repetition or bits after reduction comprises:
when *N_{data}* < *N_{RM1}*, starting from the S1^{th} group to the M^{th} group in the M groups, corresponding to a preconfigured first start position, in the virtual IR buffer module, sequentially outputting the coded bits on which the interleaving processing is performed, until the quantity of the bits after reduction reaches *N_{data}*.

## Patentansprüche

1. Verfahren zur Codierungsratenanpassungsverarbeitung, umfassend:
Aufteilen (101) der Ausgabe von N codierten Bits mittels eines Polar-Encoders auf M Gruppen und Durchführen von verschachtelter Verarbeitung, separat an den codierten Bits in der 1. Gruppe bis zur M-ten Gruppe, wobei N und M positive Ganzzahlen sind;
sequenzielles Ausgeben (201) von *N_{RM1}* codierten Bits, an denen die verschachtelte Verarbeitung durchgeführt wird, beginnend ab der 1. Gruppe, in ein virtuelles IR-Puffermodul, wobei *N_{RM1}*=min(*N,N_{1R}*), *N_{RM1}* eine positive Ganzzahl ist und *N_{1R}* eine Größe des virtuellen IR-Puffermoduls wiedergibt;
Vergleichen (203) von *N_{data}*, einer Menge verfügbarer Bits eines Übertragungskanals, mit *N_{RM1}* und Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, wobei *N_{data}* eine positive Ganzzahl ist; und
Verketten und Senden (104) der Bits nach Wiederholung oder Reduktion durch den Übertragungskanal, wobei eine Menge der Bits nach Wiederholung oder der Bits nach Reduktion gleich *N_{data}* ist.

2. Verfahren nach Anspruch 1, wobei das Vergleichen (203) von *N_{data}*, einer Menge verfügbarer Bits eines Übertragungskanals, mit *N_{RM1}* und das Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, umfasst:
Wenn *N_{data}* > *N_{RM1}*: Durchführen von Wiederholungsverarbeitung an den in dem virtuellen IR-Puffermodul gespeicherten codierten Bits, um die Bits nach Wiederholung zu erhalten.

3. Verfahren nach Anspruch 1 oder 2, wobei das Vergleichen (203) von *N_{data}*, einer Menge verfügbarer Bits eines Übertragungskanals, mit *N_{RM1}* und Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, umfasst:
Wenn, beginnend mit der S1. Gruppe bis zur M. Gruppe in den M Gruppen, *N_{data} > N_{RM1}*: Sequenzielles und zyklisches Ausgeben der codierten Bits, an denen die verschachtelte Verarbeitung durchgeführt wird, bis die Menge der Bits nach Wiederholung *N_{data}* erreicht.

4. Verfahren nach Anspruch 1, wobei das Vergleichen (203) von *N_{data}*, einer Menge verfügbarer Bits eines Übertragungskanals, mit *N_{RM1}* und Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, umfasst:
Wenn *N_{data}* < *N_{RM1}*: Durchführen von Reduktionsverarbeitung an den in dem virtuellen IR-Puffermodul gespeicherten codierten Bits, um die reduzierten Bits zu erhalten.

5. Verfahren nach Anspruch 1 oder 4, wobei das Vergleichen (203) von *N_{data}*, einer Menge verfügbarer Bits eines Übertragungskanals, mit *N_{RM1}* und Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, umfasst:
Wenn, beginnend mit der S1. Gruppe bis zur M. Gruppe in den M Gruppen, *N_{data} < N_{RM1}*: Entsprechend einer voreingestellten ersten Startposition in dem virtuellen IR-Puffermodul, sequenzielles Ausgeben der codierten Bits, an denen die verschachtelte Verarbeitung durchgeführt wird, bis die Menge der Bits nach Reduktion *N_{data}* erreicht.

6. Vorrichtung zur Codierungsratenanpassungsverarbeitung, umfassend:
ein Teilungsmodul (11), ausgelegt zum Aufteilen der Ausgabe von N codierten Bits mittels eines Polar-Encoders auf M Gruppen, wobei N und M positive Ganzzahlen sind;
ein Verschachtelungsverarbeitungsmodul (12), ausgelegt zum Durchführen von verschachtelter Verarbeitung, separat an den codierten Bits in der 1. Gruppe bis zur M. Gruppe;
ein erstes Ratenanpassungsmodul (13), ausgelegt zum sequenziellen Ausgeben von *N_{RM1}* codierten Bits, an denen die verschachtelte Verarbeitung durchgeführt wird, beginnend mit der 1. Gruppe, in ein virtuelles IR-Puffermodul, wobei *N_{RM1}*=min(*N,N_{1R}*), *N_{RM1}* eine positive Ganzzahl ist und *N_{1R}* eine Größe des virtuellen IR-Puffermoduls wiedergibt;
ein zweites Ratenanpassungsmodul (15), ausgelegt zum Vergleichen von *N_{data}*, einer Menge verfügbarer Bits eines Übertragungskanals, mit *N_{RM1}* und Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, wobei *N_{data}* eine positive Ganzzahl ist;
ein Erfassungsmodul (16) für codierte Bits, ausgelegt zum Verketten und Senden der Bits nach Wiederholung oder Reduktion durch den Übertragungskanal, wobei eine Menge der wiederholten oder reduzierten Bits gleich *N_{data}* ist.

7. Vorrichtung nach Anspruch 6, wobei das zweite Ratenanpassungsmodul (15) umfasst: eine Bitwiederholungsverarbeitungseinheit (152), ausgelegt, wenn *N_{data}* > *N_{RM1}*, beginnend mit der S1. Gruppe bis zur M. Gruppe in den M Gruppen, zum sequenziellen und zyklischen Ausgeben der codierten Bits, an denen die verschachtelte Verarbeitung durchgeführt wird, bis die Menge der Bits nach Wiederholung *N_{data}* erreicht.

8. Vorrichtung nach Anspruch 6, wobei das zweite Ratenanpassungsmodul (15) umfasst: eine Bitreduktionsverarbeitungseinheit (151), ausgelegt, wenn *N_{data} < N_{RM1}*, beginnend mit der S1. Gruppe bis zur M. Gruppe in den M Gruppen, entsprechend einer voreingestellten ersten Startposition in dem virtuellen IR-Puffermodul, zum sequenziellen Ausgeben der codierten Bits, an denen die verschachtelte Verarbeitung durchgeführt wird, bis die Menge der Bits nach Reduktion *N_{data}* erreicht.

9. Computerlesbares Speichermedium, das ein Programm speichert, das bei Ausführung des Programms durch einen Computer den Computer zum Durchführen der Schritte veranlasst:
Aufteilen (101) der Ausgabe von N codierten Bits mittels eines Polar-Encoders auf M Gruppen und Durchführen von verschachtelter Verarbeitung, separat an den codierten Bits in der 1. Gruppe bis zur M-ten Gruppe, wobei N und M positive Ganzzahlen sind;
sequenzielles Ausgeben (201) von *N_{RM1}* codierten Bits, an denen die verschachtelte Verarbeitung durchgeführt wird, beginnend ab der 1. Gruppe, in ein virtuelles IR-Puffermodul, wobei *N_{RM1}*=min(*N,N_{1R}*), *N_{RM1}* eine positive Ganzzahl ist und *N_{1R}* eine Größe des virtuellen IR-Puffermoduls wiedergibt;
Vergleichen (203) von *N_{data}*, einer Menge verfügbarer Bits eines Übertragungskanals, mit *N_{RM1}* und Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, wobei *N_{data}* eine positive Ganzzahl ist; und
Verketten und Senden der Bits nach Wiederholung oder der Bits nach der Reduktion durch den Übertragungskanal.

10. Computerlesbares Speichermedium nach Anspruch 9, wobei das Vergleichen (203) von *N_{data}*, einer Menge verfügbarer Bits eines Übertragungskanals, mit *N_{RM1}* und das Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, umfasst:
Wenn, beginnend mit der S1. Gruppe bis zur M. Gruppe in den M Gruppen, *N_{data} > N_{RM1}*: Sequenzielles und zyklisches Ausgeben der codierten Bits, an denen die verschachtelte Verarbeitung durchgeführt wird, bis die Menge der Bits nach Wiederholung *N_{data}* erreicht.

11. Computerlesbares Speichermedium nach Anspruch 9, wobei das Vergleichen (203) von *N_{data}*, einer Menge verfügbarer Bits eines Übertragungskanals, mit *N_{RM1}* und das Durchführen, entsprechend einem Vergleichsergebnis, von Wiederholungs- oder Reduktionsverarbeitung an den in dem virtuellen IR-Puffermodul gespeicherten codierten Bits, um Bits nach Wiederholung oder Bits nach Reduktion zu erhalten, umfasst:
Wenn, beginnend mit der S1. Gruppe bis zur M. Gruppe in den M Gruppen, *N_{data} < N_{RM1}*: Entsprechend einer voreingestellten ersten Startposition in dem virtuellen IR-Puffermodul, sequenzielles Ausgeben der codierten Bits, an denen die verschachtelte Verarbeitung durchgeführt wird, bis die Menge der Bits nach Reduktion *N_{data}* erreicht.

## Revendications

1. Procédé de traitement d'adaptation de débit pour du codage, comprenant :
la division (101) de N bits codés délivrés par un codeur polaire en M groupes, et la réalisation d'un traitement d'entrelacement sur les bits codés dans le 1^{er} groupe jusqu'au M^{ième} groupe séparément, dans lequel N et M sont des entiers positifs ;
la délivrance séquentielle (201) de *N*_{*RM*1} bits codés sur lesquels le traitement d'entrelacement est effectué, en partant du 1^{er} groupe, à un module tampon IR virtuel, dans lequel *N*_{*RM*1} = min(N, *N_{IR}*), *N*_{*RM*1} est un entier positif, et *N_{IR}* représente une taille du module tampon IR virtuel ;
la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction, dans lequel *N_{data}* est un entier positif ; et
la concaténation et l'envoi (104), à travers la voie de transmission, des bits après répétition ou réduction, dans lequel une quantité des bits après répétition ou des bits après réduction est égale à *N_{data}.*

2. Procédé selon la revendication 1, dans lequel la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction comprennent :
quand *N_{data}* > *N*_{*RM*1}, la réalisation d'un traitement de répétition sur les bits codés stockés dans le module tampon IR virtuel, pour obtenir les bits après répétition.

3. Procédé selon la revendication 1 ou 2, dans lequel la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction comprennent :
quand *N_{data}* > *N*_{*RM*1}, en partant du S1^{ième} groupe jusqu'au M^{ième} groupe dans les M groupes, la délivrance séquentielle et cyclique des bits codés sur lesquels le traitement d'entrelacement est effectué, jusqu'à ce que la quantité des bits après répétition atteigne *N_{data}.*

4. Procédé selon la revendication 1, dans lequel la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction comprennent :
quand *N_{data} < N*_{*RM*1}, la réalisation d'un traitement de réduction sur les bits codés stockés dans le module tampon IR virtuel, pour obtenir les bits réduits.

5. Procédé selon la revendication 1 ou 4, dans lequel la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction comprennent :
quand *N_{data} < N*_{*RM*1}, en partant du S1^{ième} groupe jusqu'au M^{ième} groupe dans les M groupes, correspondant à une première position de départ préconfigurée, dans le module tampon IR virtuel, la délivrance séquentielle des bits codés sur lesquels le traitement d'entrelacement est effectué, jusqu'à ce que la quantité des bits après réduction atteigne *N_{data}.*

6. Appareil de traitement d'adaptation de débit pour du codage, comprenant :
un module de division (11), configuré pour diviser N bits codés délivrés par un codeur polaire en M groupes, dans lequel N et M sont des entiers positifs ;
un module de traitement d'entrelacement (12), configuré pour réaliser un traitement d'entrelacement sur les bits codés dans le 1^{er} groupe jusqu'au M^{ième} groupe séparément ;
un premier module d'adaptation de débit (13), configuré pour délivrer séquentiellement *N*_{*RM*1} bits codés sur lesquels le traitement d'entrelacement est effectué, en partant du 1^{er} groupe, à un module tampon IR virtuel, dans lequel *N*_{*RM*1} = min(*N*, *N_{IR}*), *N*_{*RM*1} est un entier positif, et *N_{IR}* représente une taille du module tampon IR virtuel ;
un deuxième module d'adaptation de débit (15), configuré pour comparer *N_{data}*, une quantité de bits disponibles d'une voie de transmission, avec *N*_{*RM*1}, et réaliser, en fonction d'un résultat de comparaison, un traitement de répétition ou de réduction sur les bits codés stockés dans le module tampon IR virtuel, pour obtenir des bits après répétition ou des bits après réduction, dans lequel *N_{data}* est un entier positif ;
un module de collecte de bits codés (16), configuré pour concaténer et envoyer, à travers la voie de transmission, les bits après répétition ou réduction, dans lequel une quantité des bits répétés ou des bits réduits est égale à *N_{data}.*

7. Appareil selon la revendication 6, dans lequel le deuxième module d'adaptation de débit (15) comprend :
une unité de traitement de répétition de bits (152), configurée pour : quand *N_{data} > N*_{*RM*1}, en partant du S1^{ième} groupe jusqu'au M^{ième} groupe dans les M groupes, délivrer séquentiellement et cycliquement les bits codés sur lesquels le traitement d'entrelacement est effectué, jusqu'à ce que la quantité des bits après répétition atteigne *N_{data}.*

8. Appareil selon la revendication 6, dans lequel le deuxième module d'adaptation de débit (15) comprend :
une unité de traitement de réduction de bits (151), configurée pour : quand *N_{data} < N*_{*RM*1}, en partant du S1^{ième} groupe jusqu'au M^{ième} groupe dans les M groupes, correspondant à une première position de départ préconfigurée, dans le module tampon IR virtuel, délivrer séquentiellement les bits codés sur lesquels le traitement d'entrelacement est effectué, jusqu'à ce que la quantité des bits après réduction atteigne *N_{data}.*

9. Support de stockage lisible par ordinateur stockant un programme qui, quand le programme est exécuté par un ordinateur, conduit l'ordinateur à réaliser les étapes de :
division (101) de N bits codés délivrés par un codeur polaire en M groupes, et réalisation d'un traitement d'entrelacement sur les bits codés dans le 1^{er} groupe jusqu'au M^{ième} groupe séparément, dans lequel N et M sont des entiers positifs ;
délivrance séquentielle (201) de *N*_{*RM*1} bits codés sur lesquels le traitement d'entrelacement est effectué, en partant du 1^{er} groupe, à un module tampon IR virtuel, dans lequel *N*_{*RM*1} = min(N, *N_{IR}*), *N*_{*RM*1} est un entier positif, et *N_{IR}* représente une taille du module tampon IR virtuel ;
comparaison (203) de *N_{data}*, une quantité de bits disponibles d'une voie de transmission, avec *N*_{*RM*1}, et réalisation, en fonction d'un résultat de comparaison, d'un traitement de répétition ou de réduction sur les bits codés stockés dans le module tampon IR virtuel, pour obtenir des bits après répétition ou des bits après réduction, dans lequel *N_{data}* est un entier positif ; et
concaténation et envoi, à travers la voie de transmission, des bits après répétition ou des bits après réduction.

10. Support de stockage lisible par ordinateur selon la revendication 9, dans lequel la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction comprennent :
quand *N_{data}* > *N*_{*RM*1}, en partant du S1^{ième} groupe jusqu'au M^{ième} groupe dans les M groupes, la délivrance séquentielle et cyclique des bits codés sur lesquels le traitement d'entrelacement est effectué, jusqu'à ce que la quantité des bits après répétition atteigne *N_{data}.*

11. Support de stockage lisible par ordinateur selon la revendication 9, dans lequel la comparaison (203) de *N_{data}*, une quantité de bits disponibles d'une voie de transmission, avec *N*_{*RM*1}, et la réalisation, en fonction d'un résultat de comparaison, d'un traitement de répétition ou de réduction sur les bits codés stockés dans le module tampon IR virtuel, pour obtenir des bits après répétition ou des bits après réduction comprennent :
quand *N_{data} < N*_{*RM*1}, en partant du S1^{ième} groupe jusqu'au M^{ième} groupe dans les M groupes, correspondant à une première position de départ préconfigurée, dans le module tampon IR virtuel, la délivrance séquentielle des bits codés sur lesquels le traitement d'entrelacement est effectué, jusqu'à ce que la quantité des bits après réduction atteigne *N_{data}.*
